# EUROPÄISCHE PATENTANMELDUNG

(11) **EP 0 558 871 A1**
(43) Veröffentlichungstag der Anmeldung: **08.09.1993**
(21) Anmeldenummer: 92810159.1
(22) Anmeldetag: 03.03.1992
(51) Int. Cl.: H03K 17/968, H03K 17/969

(54) **Taste aufgebaut in Schichten aus Folien**

(71) Anmelder: ELMA ELECTRONIC AG, CH-8620 Wetzikon (CH)
(72) Erfinder: Limberger, Dieter, CH-8625 Gossau (CH)
(74) Vertreter: Heubeck, Bernhard

(57) **Zusammenfassung**

Die Taste ist schichtartig aufgebaut aus einer Auflagefolie (3), einer Mittelfolie (2) sowie einer Deckfolie (1), wobei die Mittelfolie (2) eine Ausnehmung für eine Messvorrichtung (5) aufweist. Zwischen der Messvorrichtung (5) und der Deckfolie (1) besteht ein Hohlraum (14), wobei ein über dem Hohlraum (14) von aussen auf die Deckfolie (1) ausgeübter Druck eine elastische Verformung in diesen Bereich und damit eine Verringerung des Abstandes (b) zwischen der Folie (1) und der Messvorrichtung (5) bewirkt. Die Messvorrichtung (5) bestimmt den Abstand (b) durch eine optisches Messprinzip mittels eines Licht emittierenden Elementes (6) sowie eines Licht sammelnden Elementes (7). Die erfindungsgemässen Tasten lassen sich in eine schichtartig aufgebaute Tastatur integrieren.

## Beschreibung

Die Erfindung bezieht sich auf eine Taste aufgebaut in Schichten aus Folien gemäss dem Oberbegriff des Anspruchs 1. Sie betrifft weiter eine Tastatur bestehend aus erfindungsgemässen Tasten.

Es sind bereits zahlreiche Tasten und entsprechende Tastaturen in Folien-Schichtaufbau für passive Schalter wie Kontakte oder Widerstände bekannt. Dabei ist üblicherweise ein erheblicher Tastenweg notwendig, was einen entsprechend elastischen Folienaufbau bedingt. Mit solchen Tasten bzw. Tastaturen lässt sich keine ermüdungsfreie Anordnung erzielen, da der Tastenkontakt und die Folie bei jeder Betätigung bewegt und verformt wird, was nach einer gewissen Gebrauchsdauer zu Fehlkontakten oder sogar zu Schäden führen kann.

Weiter sind Tasten und Tastaturen in Folien-Schichtaufbau unter Verwendung piezoelektrischer Kristallelemente vorgeschlagen worden (vgl. EP 0 210 386). Dabei sind die druckempfindlichen Kristallelemente derart zwischen den Folien angeordnet, dass die Betätigung praktisch weglos erfolgt. Die relativ dünne Deckfolie der Folientastatur bietet ungenügenden Schutz vor Beschädigung, insbesondere bei Anwendungen an öffentlich zugänglichen Geräten welche zunehmendem Vandalismus ausgesetzt sind. Deshalb sind Abdeckungen für die Betätigungsflächen von Folientastaturen geschaffen worden (vgl. CH 675 028). Piezoelektrische Tastaturen mit derartigen Abdeckungen weisen verschiedene Nachteile auf. So verursacht die Abdeckung zum Beispiel ein Übersprechen zwischen den einzelnen Betätigungsflächen. Weiter sind derartige Tastaturen sehr empfindlich auf Vibrationen, was zum Beispiel deren Anwendbarkeit im öffentlichen Verkehr einschränkt. Weiter ist es schwierig, derartige Tastaturen spannungsfrei zu befestigen, oder die, zum Beispiel durch Umwelteinflüsse wie grössere Temperaturschwankungen, verursachen Spannungen in der Tastatur zu kompensieren, sodass auf die entsprechenden Kristallelemente ein Druck ausgeübt wird. Eine präzise Auslösung wird dadurch behindert.

Der Erfindung liegt die Aufgabe zugrunde, eine Taste sowie eine Tastatur mit mehreren Tasten in Folienaufbau beziehungsweise in Schichtaufbau zu schaffen, welche die erwähnten Nachteile nicht oder nur im verminderten Masse aufweist.

Dies wird durch eine Taste mit den kennzeichnenden Merkmalen des Anspruches 1 erreicht.

Die Taste ist schichtartig aufgebaut aus einer Auflagefolie, einer Mittelfolie sowie einer Deckfolie, wobei die Mittelfolie eine Ausnehmung für eine Messvorrichtung aufweist. Zwischen der Messvorrichtung und der Deckfolie besteht ein Hohlraum, wobei ein über dem Hohlraum von aussen auf die Deckfolie ausgeübter Druck eine elastische Verformung in diesen Bereich und damit eine Verringerung des Abstandes zwischen der Deckfolie und der Messvorrichtung bewirkt. Die Messvorrichtung bestimmt diesen Abstand durch eine optisches Messprinzip mittels eines Licht emittierenden Elementes sowie eines Licht sammelnden Elementes. Die erfindungsgemässen Tasten lassen sich in eine schichtartig aufgebaute Tastatur integrieren.

Im folgenden werden Ausführungsbeispiele der Erfindung an Hand von Zeichnungen näher erläutert. Es zeigt
- Fig. 1a: eine Schnittansicht durch eine Folientaste mit Schichtaufbau und einer Messvorrichtung;
- Fig. 1b: eine Schnittansicht durch eine Folientaste mit Schichaufbau und einer weiteren Messvorrichtung;
- Fig. 2a: eine perspektivische Ansicht der Messvorrichtung;
- Fig. 2b: eine perspektivische Ansicht eines Längsschnittes durch die Messvorrichtung;
- Fig. 2c: eine perspektivische Ansicht eines Längsschnittes durch die weitere Messvorrichtung;
- Fig. 3: Charakteristik des Ausgangssignal einer Messvorrichtung;
- Fig. 4: eine perspektivische Ansicht einer Tastatur, aufgebaut aus einzelnen Tasten;
- Fig. 5: eine Schnittansicht einer weiteren Ausführungsform der Taste;
- Fig. 6: eine Schnittansicht einer weiteren Ausführungsform der Taste;
- Fig. 7: eine Schnittansicht einer weiteren Ausführungsform der Taste.

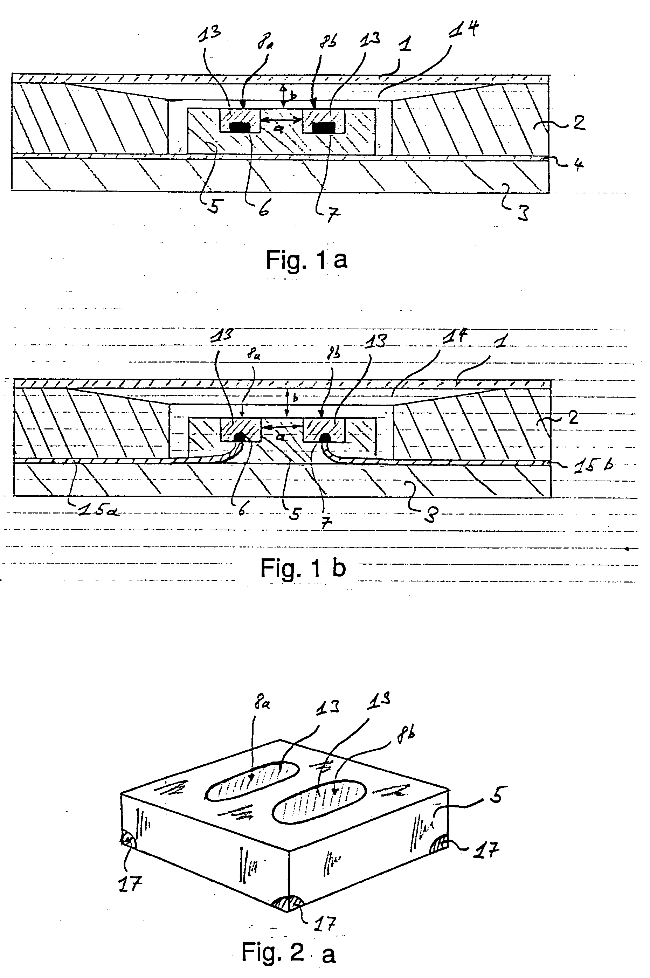

Fig. 1a zeigt eine Folientaste mit den Folien 1, 2, 3 und der Messvorrichtung 5. Die Folie 3 bildet die Auflage für die weiteren Bestandteile der Taste und kann aus bekannten Kunststoffmaterialien, z.B. Polyester oder Polycarbonat bestehen. Die Dicke der Folie 3 ist bei einer typischen Folientastatur ca. 0,1 mm kann aber in einem weiten Bereich frei gewählt werden. Anstelle der Folie 3 kann auch eine Platte beliebiger Dicke aus Kunststoff oder auch aus Materialien wie z.B. Metall vorgesehen werden. Auf der Folie 3 liegt eine Folie 2, welche an der vorgesehenen Tastenstelle eine Ausnehmung bildet, in der die Messvorrichtung 5 Platz findet. Ueber der Mittelfolie 2 liegt eine Deckfolie 1, deren Dicke typischerweise zwischen 0,1 mm und 0,5 mm liegt. Die Deckfolie 1 kann ebenfalls aus einem bekannten Kunststoff oder aus Metall gefertigt sein. Die Messvorrichtung 5 bestimmt durch ein optisches Messprinzip den Abstand b zur Deckfolie 1. Ein über dem Hohlraum 14 von aussen auf die Deckfolie 1 ausgeübter Druck bewirkt eine elastische Verformung der Deckfolie 1 in diesem Bereich und damit eine Verringerung des Abstandes b zwischen der Folie 1 und der Messvorrichtung 5. Die Deckfolie 1 im Bereich über der Messvorrichtung 5 muss daher in geringem Masse elastisch verformbar sein, weshalb die Dicke der Mittelfolie 2 mindestens um so viel grösser als die Bauhöhe der Messvorrichtung 5 gewählt werden muss, dass die Deckfolie 1 bei einer Tastenbetätigung die Messvorrichtung 5 nicht oder nicht wesentlich berührt. Die Verringerung des Abstandes b bei einer Tastenbetätigung liegt üblicherweise im Bereich von einem bis mehreren Zehntelmillimeter. Der von der Deckfolie 1 der Mittelfolie 2 und der Auflagefolie 3 umschlossene Hohlraum 14 weitet sich im dargestellten Beispiel gegen die Deckfolie 1 hin auf, was den elastisch verformbaren Bereich der Deckfolie 1 oberhalb der Messvorrichtung 5 vergrössert. Für eine mit den Fingern zu betätigende Taste beträgt der Durchmesser des elastisch verformbaren Bereichs der Deckfolie 1 ungefähr 10 mm, kann aber je nach Verwendungszweck der Tastatur und je nach der Dimensionierung der Messvorrichtung 5 in weiten Bereichen gewählt werden. Die Messvorrichtung 5 besteht aus einem Licht emittierenden Element 6 sowie aus einem Licht sammelnden Element 7, die einen Abstand a aufweisen. Diese beiden Elemente sind in einen, bezüglich der verwendeten Lichtwellenlänge transparenten Körper 13 eingelassen, wobei die Austrittsöffnung 8a sowie die Eintrittsöffnung 8b z.B. als Linse oder auch als plane Fläche ausgestaltet sein können. Die Elemente 6 und 7 lassen sich mit elektronischen Bauteilen z.B. mit einer LED (Light Emitting Diode) sowie mit einem photosensitiven Halbleiter realisieren, wobei der transparente Körper 13 üblicherweise ein Bestandteil dieser elektronischen Bauteile bildet. Die elektrischen Zu- und Ableitungen für die Messvorrichtung 5 werden z.B. mit einer Schicht aus Leiterbahnen 4 realisiert, wobei diese Schicht zum Beispiel zwischen die Mittelfolie 2 und die Auflagefolie 3 zu liegen kommt. Selbstverständlich können die Auflageschicht 3 sowie die Leiterbahnen 4 auch gemeinsam vorgefertigt sein z.B. als mit Leiterbahnen bedruckte Folie oder auch als Leiterplatte wie eine Kupferleiterplatte.

Fig. 1b zeigt eine Folientaste mit einer Messvorrichtung 5, die aus einem passiven, Licht emittierenden Element 6 und einem passiven Licht sammelnden Element 7 besteht. Dabei wird das abzustrahlende Licht über einen Lichtleiter 15a der Messvorrichtung 5 zugeführt und das empfangene Licht über einen weiteren Lichtleiter 15b wieder abgeführt. Der Lichtleiter 15a ist mit einer nicht dargestellten Lichtquelle, und der Lichtleiter 15b mit einer nicht dargestellten, lichtempfindlichen Sensor verbunden. Lichtquelle und Lichtsensor können in der Taste integriert sein oder auch ausserhalb der Taste untergebracht werden.

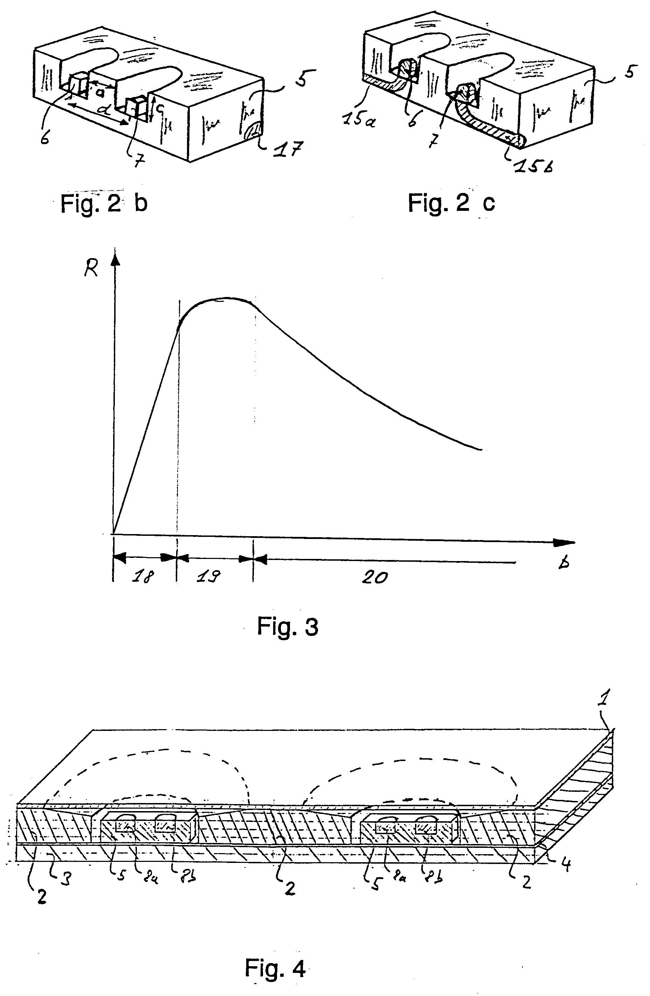

Fig. 2a zeigt ein Ausführungsbeispiel einer Messvorrichtung 5, bei der das Licht emittierende Element mit Austrittsöffnung 8a und das Licht sammelnde Element mit Eintrittsöffnung 8b im gleichen Gehäuse intergriert sind. Natürlich können die beiden Elemente auch als einzelne, getrennt ausgeführte Bauteile im Hohlraum 14 angeordnet sein, oder in die Mittelfolie 2 eingelassen sein.

Fig. 2b zeigt einen Längsschnitt durch die Messvorrichtung 5. Das Licht emittierende Element 6 ist im Glaskörper 13 untergebracht und wird in dieser Ausführungsweise zusammen mit dem Glaskörper 13 vorzugsweise aus einer Licht emittierenden Diode (LED) gebildet. Ebenso ist das Licht sammelnde Element 7 ein lichtempfindlicher elektronischer Sensor, wobei der Glaskörper 13 üblicherweise ein Bestandteil des Sensors ist. Die Elemente 6 und 7 sind über die elektrischen Kontakte 17 z.B. mit Leiterbahnen 4 kontaktierbar. Die Elemente 6 und 7 sind in einem Abstand a voneinander distanziert, wobei der Abstand zwischen dem Zentrum des lichterzeugenden Elementes 6 und dem Zentrum des Licht sammelnden Elementes 7, d beträgt. Die Einbautiefe der beiden Elemente 6 und 7 innerhalb der Messvorrichtung 5 ist mit c bezeichnet.

Fig. 2c zeigt einen weiteren Längsschnitt durch eine Messvorrichtung 5, bei der das Licht über einen Lichtleiter 15a dem Licht emittierenden Element 6 zugeführt wird, und das Licht über einen Lichtleiter 15b vom Licht sammelnden Element 7 abgeführt wird. Die Elemente 6 und 7 sind üblicherweise je in einen transparenten Körper 13 eingelassen, der unter anderem zur optischen Lichtführung dient.

Fig. 3 zeigt das relative Ausgangssignal R der Messvorrichtung 5 in Funktion der Distanz b zwischen Deckfolie 1 und Messvorrichtung 5. Dabei lassen sich grundsätzlich drei Messbereiche unterscheiden. Im Bereich 18 zeigt sich eine lineare Zunahme des Ausgangssignals R in Abhängigkeit von b. In diesem Bereich sind das Licht emittierende Element 6 sowie das Licht sammelnde Element 7, unter anderem durch die Wahl des Abstandes a, so angeordnet, dass das durch die Austrittsöffnung 8a austretende Licht nur über mehrfache Relexionen zwischen der Deckfolie 1 und der Oberfläche der Messvorrichtung 5 zur Eintrittsöffnung 8b gelangt. Dies trifft zum Beispiel mit den in Fig. 2b gewählten Dimensionen der Abstände a, c und d insbesondere dann zu, wenn der Abstand b kleiner als die Hälfte des Abstandes a ist. Die Anordnung der Elemente 6 und 7 sowie der Abstand b können auch so gewählt werden, dass das Licht über die Austrittsöffnung 8a vorzugsweise durch eine einmalige Reflektion an der Deckfolie 1 zur Eintrittsöffnung 8b des Licht sammelnden Elementes 7 gelangt. Dies bewirkt eine Charakteristik der Messvorrichtung 5 gemäss Bereich 20. Zur Detektierung kleiner Aenderungen des Abstandes b eignet sich besonders der Bereich 18, wogegen sich der Bereich 20 besonders für die berührungslose Dedektierung von grossen Tastenhüben eignet. Der Bereich 19 ist ein Uebergangsbereich zwischen den Bereichen 18 und 20, und eignet sich schlecht für eine Abstandsmessung.

Fig. 4 zeigt eine Tastatur, die aus einzelnen, bereits beschriebenen Tastenelementen aufgebaut ist. Die Schichtbauweise erlaubt es, eine beliebige Anzahl von Tastenelementen im gleichen Schichtaufbau zu einer Tastatur zu integrieren. Elektrische Anschlüsse für die Messvorrichtungen 5 lassen sich über Leiterbahnen 4 herstellen. Am Rande der Tastatur können die Leiterbahnen 4 für Zuleitungsanschlüsse z.B. auch freigelegt sein. Die Leiterbahnen können auf einem Folienfortsatz weggeführt werden der an seinem Ende z.B. mit einer (nicht dargestellten) Steckverbindung versehen wird.

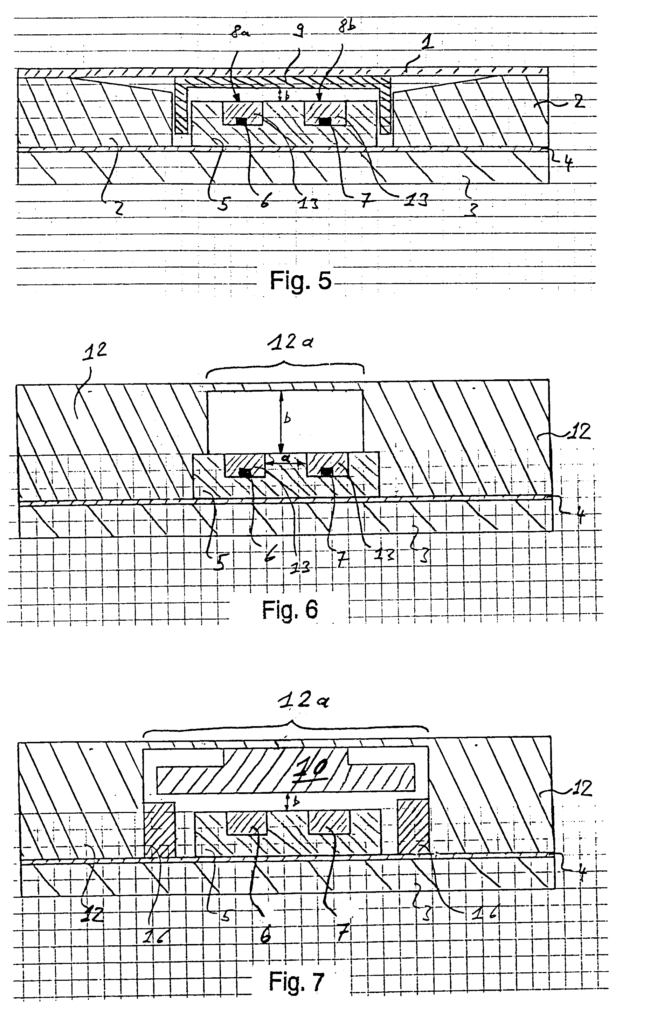

Fig. 5 zeigt eine weitere Ausführungsform einer Taste. Wird im Bereich einer Messvorrichtung 5 mit einer grossen Kraft auf die darüber liegende Deckfolie 1 gedrückt, so besteht die Gefahr, dass die Deckfolie 1 mit der Messvorrichtung 5 in Berührung kommt, oder dass die Messvorrichtung 5 beschädigt wird, oder dass die Deckfolie 1 über ihren elastischen Bereich hinaus gedehnt wird. Ein Hubbegrenzungselement 9 begrenzt den Tastenweg der Deckfolie 1 indem die U-förmig gebildeten Verlängerungen des Begrenzungselementes 9 auf der Auflagefolie 3 oder auf den Leiterbahnen 4 aufliegen, und somit den Tastenweg b begrenzen.

Fig. 6 zeigt eine Taste, bei der die Mittelfolie 2 und die Deckfolie 1 zu einer Deckplatte 12 zusammengefasst sind, die so dick gewählt werden kann, dass ein guter mechanischer Schutz der darunter angeordneten Taste mit Messvorrichtung 5 besteht. Als Material wird dabei z.B. Aluminium verwendet. Die Deckplatte 12 weist über der Messvorrichtung 5 einen elastisch verformbaren Bereich 12a auf. Bei einer Deckplatte 12 aus Aluminium von z.B. 5 mm Dicke kann der elastisch verformbare Bereich 12a je nach Durchmesser z.B. 0,5 bis 2 mm Dicke aufweisen. In diesem Ausführungsbeispiel ist der Abstand b markant grösser als der Abstand a weshalb mit der Messvorrichtung 5 gemäss der Beschreibung zu Fig. 3 im Bereich 20 gemessen wird.

Fig. 7 zeigt eine weitere Taste mit einer Deckplatte 12 und einem elastisch verformbaren Bereich 12a. Ein mit dem Bereich 12a teilweise verbundenes Begrenzungselement 10 bewirkt einen kleinen Abstand b, was gemäss Fig. 3 eine Messung des Abstandes b im Bereich 18 erlaubt. Ein Distanzelement 16 bewirkt eine Hubbegrenzung, indem bei einem grossen Tastendruck das Begrenzungselement 10 auf dem Distanzelement 16 aufliegt.

## Patentansprüche

1. Taste aufgebaut in Schichten mit einer Auflagefolie (3), einer Mittelfolie (2) sowie einer Deckfolie (1), wobei die Mittelfolie (2) eine Ausnehmung für eine Messvorrichtung (5) aufweist, dadurch gekennzeichnet, dass mindestens zwischen der Deckfolie (1) und der Messvorrichtung (5) ein Hohlraum (14) besteht, dass die Deckfolie (1) elastische Eigenschaften besitzt, um einen geringen Tastenweg zu ermöglichen, dass die Messvorrichtung (5) aus einem Licht emittierenden Element (6) sowie einem Licht sammelnden Element (7) besteht, dass die Messvorrichtung (5) den Abstand (b) zur Deckfolie (1) berührungslos optisch feststellt, und dass das über die Austrittsöffnung (8a) emittierte Licht nur indirekt durch die Eintrittsöffnung (8b) auf das Licht sammelnde Element (7) auftrifft.

2. Taste nach Anspruch 1, dadurch gekennzeichnet, dass das Licht emittierende Element (6) und das Licht sammelnde Element (7) gemeinsam in einem einzigen Bauelement als Messvorrichtung (5) integriert sind.

3. Taste nach Anspruch 1, dadurch gekennzeichnet, dass das Licht emittierende Element (6) und das Licht sammelnde Element (7) zwei getrennte Elemente bilden, die zusammen die Messvorrichtung (5) bilden.

4. Taste nach einem der Ansprüche 1 bis 3, dadurch gekennzeichnet, dass die Messvorrichtung (5) derart ausgelegt ist, dass ein ungefähr linearer Zusammenhang zwischen der Distanz (b) und dem relativen Ausgangssignal (R) des Licht sammelnden Elementes (7) entsteht.

5. Taste nach einem der Ansprüche 1 bis 4, dadurch gekennzeichnet, dass der Abstand (a) zwischen der Austrittsöffnung (8a) und der Eintrittsöffnung (8b) mindestens so gross ist wie der Abstand (b) zwischen den Austrittsöffnungen (8a,8b) und der Deckfolie (1), und dass das Licht emittierende Element (6) und das Licht sammelnde Element (7) derart in der Messvorrichtung (5) positioniert sind und der Strahlengang durch die Glaskörper (13) derart beeinflusst wird, dass das Licht nur über Mehrfachreflexion von der Austrittsöffnung (8a) zur Eintrittsöffnung (8b) gelangt.

6. Taste nach einem der Ansprüche 1 bis 3, dadurch gekennzeichnet, dass die Messvorrichtung (5) derart ausgelegt ist, dass ein inverser Zusammenhang zwischen der Distanz (b) und dem relativen Ausgangssignal (R) des Licht sammelnden Elementes (7) entsteht.

7. Taste nach einem der Ansprüche 1 bis 3 oder 6, dadurch gekennzeichnet, dass der Abstand (a) zwischen der Austrittsöffnung (8a) und der Eintrittsöffnung (8b) kleiner als der Abstand (b) zwischen den Austrittsöffnungen (8) und der Deckfolie (1) ist, und dass das Licht emittierende Element (6) und das Licht sammelnde Element (7) derart in der Messvorrichtung (5) positioniert sind und der Strahlengang durch die Glaskörper (13) derart beeinflusst wird, dass das Licht von der Austrittsöffnung (8a) über eine Einfachreflexion an der Deckfolie (1) zur Eintrittsöffnung (8b) gelangt.

8. Taste nach einem der Ansprüche 1 bis 7, dadurch gekennzeichnet, dass das Licht emittierende Element (6) aus einer Leuchtdiode besteht sowie das Licht sammelnde Element (7) aus einem lichtempfindlichen elektronischen Sensor.

9. Taste nach einem der Ansprüche 1 bis 8, dadurch gekennzeichent, dass die Auflagefolie (3) mit Leiterbahnen (4) zur elektrischen Kontaktierung der Kontaktflächen (17) der Messvorrichtung (5) versehen ist.

10. Taste nach einem der Ansprüche 1 bis 9, dadurch gekennzeichnet, dass die Messvorrichtung (5) eine Verstärker und/oder Logikschaltung umfasst.

11. Taste nach einem der Ansprüche 1 bis 7, dadurch gekennzeichnet, dass dem Licht emittierenden Element (6) das Licht über einen Lichtleiter (15a) zugeführt wird, und dass das gesammelte Licht des Elementes (7) über einen Lichtleiter (15b) einem lichtempfindlichen elektronischen Sensor zugeführt wird.

12. Taste nach einem der Ansprüche 1 bis 7 oder 11, dadurch gekennzeichnet, dass Lichtleiter (15) in die Mittelfolie (2) integriert sind oder zwischen der Auflagefolie (3) und der Mittelfolie (2) Platz finden.

13. Taste nach einem der Ansprüche 1 bis 12, dadurch gekennzeichnet, dass die Ausnehmung für die Messvorrichtung (5) in der Mittelfolie (2) einen Durchmesser aufweist, welcher grösser ist als der Durchmesser der Messvorrichtung (5).

14. Taste nach einem der Ansprüche 1 bis 13, dadurch gekennzeichnet, dass ein an der Deckfolie (1) befestigtes Hubbegrenzungselement (9) die Deckfolie (1) vor Überdehnung und/oder die Messvorrichtung (5) vor Beschädigung schützt.

15. Taste nach einem der Ansprüche 1 bis 13, dadurch gekennzeichnet, dass die Deckfolie (1) und die Mittelfolie (2) durch eine Deckplatte (12) gebildet wird, die über der Messvorrichtung (5) eine Ausnehmung besitzt, derart, dass die Deckplatte (12) im Bereich (12a) elastisch verformbar ist.

16. Taste nach Anspruch 15, dadurch gekennzeichnet, dass ein Hubbegrenzungselement (10) im Bereich (12a) teilweise mit der Deckplatte (12) verbunden ist.

17. Tastatur dadurch gekennzeichnet, dass sie einen Schichtaufbau mit Auflagefolie (3), Mittelfolie (2) und Deckfolie (1) oder mit Auflagefolie (3) und Deckplatte (12) aufweist, mit Tasten gemässen den Ansprüchen 1 bis 14.

18. Tastatur gemäss Anspruch 17, dadurch gekennzeichnet, dass auf der Auflagefolie (3) Leiterbahnen (4) zur elektrischen Kontaktierung der Messvorrichtung (5) aufgebracht sind.

19. Tastatur gemäss Anspruch 17, dadurch gekennzeichnet, dass auf der Auflagefolie (3) Lichtleiter (15) eingebracht sind zur Verbindung der Messvorrichtung (5) mit mindestens einer Lichtquelle und optischen Sensoren.
